(19) Europäisches Patentamt / European Patent Office / Office européen des brevets

(11) **EP 3 001 206 B1**

(12) **FASCICULE DE BREVET EUROPEEN**

(45) Date de publication et mention
de la délivrance du brevet:
**20.04.2022  Bulletin 2022/16**

(21) Numéro de dépôt: **15187229.8**

(22) Date de dépôt: **28.09.2015**

(51) Classification Internationale des Brevets (IPC):
**G01R 31/50** *(2020.01)*    **G01R 19/25** *(2006.01)*
**G01R 19/04** *(2006.01)*    **G01R 19/155** *(2006.01)*
**G01R 19/30** *(2006.01)*

(52) Classification Coopérative des Brevets (CPC):
**G01R 31/50; G01R 19/2513;** G01R 19/04;
G01R 19/155; G01R 19/30

(54) **PROCÉDÉ D'ESTIMATION D'UNE TENSION ET DISPOSITIF PERMETTANT UNE TELLE ESTIMATION**

VERFAHREN ZUR SPANNUNGSSCHÄTZUNG, UND VORRICHTUNG, DIE EINE SOLCHE SCHÄTZUNG ERMÖGLICHT

METHOD FOR ESTIMATING A VOLTAGE AND DEVICE ENABLING SUCH AN ESTIMATION

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité:  **29.09.2014  FR 1459196**

(43) Date de publication de la demande:
**30.03.2016  Bulletin 2016/13**

(73) Titulaire: **Schneider Electric Industries SAS**
**92500 Rueil-Malmaison (FR)**

(72) Inventeurs:
• **DROUERE, Bernard**
**38050 Grenoble Cedex 9 (FR)**
• **MECREANT, Julien**
**38050 Grenoble Cedex 9 (FR)**

(74) Mandataire: **Brevalex**
**95, rue d'Amsterdam**
**75378 Paris Cedex 8 (FR)**

(56) Documents cités:
DE-A1-102011 085 516    US-A- 4 811 236
US-A1- 2005 207 198    US-A1- 2013 158 909
US-B1- 6 246 332

# EP 3 001 206 B1

**Description**

## DOMAINE TECHNIQUE

L'invention se rapporte au domaine des circuits électriques moyenne tension et aux équipements permettant de surveiller l'état de ces circuits électriques.

## ÉTAT DE LA TECHNIQUE ANTÉRIEURE

La surveillance des circuits électriques moyenne tension au moins biphasés est une problématique essentielle pour prévenir, détecter et/ou corriger une éventuelle panne ou un éventuel dysfonctionnement de ces circuits électriques. Cette surveillance est réalisée au moyen de divers équipements permettant de connaitre notamment pour chacune des phases des circuits équipés, l'état de mise à la tension, la phase de la tension et la quantité de courant qui y transite.

On entend ci-dessus et dans le reste de ce document par circuit électrique moyenne tension, des circuits dont la tension de fonctionnement est comprise entre 1 et 35kV, généralement comprise entre 15 et 20kV. On entend par contre par circuit électrique basse tension un circuit électrique dont la tension de fonctionnement est inférieure 1kV, celle-ci étant pour la France généralement de 0,4kV. Classiquement le passage d'un circuit électrique de moyenne tension, tel qu'un réseau de distribution moyenne tension, à un circuit électrique basse tension, tel qu'une installation cliente d'un industriel ou d'un ou plusieurs particuliers, est réalisé au moyen de transformateur.

Or, pour des questions économiques, en ce qui concerne les circuits électriques moyenne tension, les équipements de surveillance sont généralement intégrés à des appareillages remplissant d'autres fonctions, telles que la coupure ou la télécommande de ces circuits. Cette intégration conditionne les technologies employées pour de tels équipements de surveillance. Ainsi, s'il est relativement facile de quantifier le courant transitant dans un circuit moyenne tension avec une précision acceptable, notamment au moyen de matériel de télé-conduite, la captation de la moyenne tension reste relativement difficile.

En effet, pour obtenir une telle information, il est connu de faire la mesure de la tension au niveau des capacités de traversée (connu sous la dénomination anglaise de « bushing »). Néanmoins, la valeur des capacités de traversée présente une forte variabilité en fonction de la température et de leur vieillissement. Ainsi, les valeurs de tensions obtenues sont peu fiables, un écart de $\pm$ 25% étant admis en France, et elles présentent surtout un déséquilibre entre les différentes phases du circuit électrique. Seule l'information concernant la phase est donc exploitable avec un tel équipement.

Pour remédier à cet inconvénient, il est connu du document EP 2731220 A1 d'utiliser les capteurs de tension d'un circuit basse tension relié au circuit moyenne tension ceci pour corriger les tensions mesurées au niveau des capacités de traversée. Les capteurs équipant les circuits basse tension ne sont généralement pas sujets à la variabilité de ceux équipant les capacités de traversée, il est donc possible d'estimer la valeur des tensions du circuit moyenne tension avec une précision de l'ordre de 0,5 à 1%. Ainsi, en combinant l'information sur la phase obtenue par les capteurs équipant les capacités de traversée avec la valeur de tension estimée à partir des capteurs du circuit basse tension, il est possible d'estimer précisément la tension de chacune des phases du circuit moyenne tension.

Néanmoins, une telle estimation de tension combinant à la fois une mesure sur le circuit moyenne tension et une mesure sur le circuit basse tension est relativement complexe à mettre en place.

On notera qu'il est également connu des documents US 2005/0207198 A1, US 2013/0158909 A1, DE 10 2011/085516 A1, US 4811236 et US 6246332 B1 des procédés de mesure de tension et/ou de détection de défauts pour des circuits polyphasés.

## EXPOSÉ DE L'INVENTION

L'invention vise à remédier à cet inconvénient et a ainsi pour but de fournir un procédé d'estimation d'une tension d'un circuit électrique au moins biphasé, tel qu'un circuit moyenne tension, ledit procédé permettant d'estimer une tension de l'une des phases dudit circuit électrique qui soit directement comparable avec une autre tension, du même type, qui serait estimée sur l'autre ou les autres phases du circuit électrique selon le même procédé ceci sans nécessiter une mesure autre que celle d'un signal représentatif d'une tension du circuit moyenne tension.

L'invention concerne à cet effet un procédé d'estimation d'une tension périodique, telle qu'une tension d'entrée, de l'une des phases d'un circuit électrique au moins biphasé comportant pour chacune de ses phases un capteur de tension, chaque capteur de tension étant apte à fournir un signal représentatif d'au moins une partie de période de la tension périodique de ladite phase, le procédé tel que défini dans la revendication indépendante 1.

Avec un tel procédé d'estimation, le gain permet de d'obtenir une tension estimée normée par rapport à une tension de référence commune à l'ensemble des phases du circuit électrique. Ainsi, la tension estimée d'une phase est comparable à la ou aux autres tensions estimées pour la ou les autres phases. De plus, ce gain étant déterminé en l'absence de défaut électrique, il permet de prendre en compte la variabilité des composants du circuit, tels que des valeurs de capacité, qui seraient équipés des capteurs de tension et du réseau électrique, et ainsi de fournir des tensions qui sont comparables entre les phases.

En effet, s'il est important de pouvoir comparer les tensions des phases entre elles, ceci pour pouvoir déterminer leurs composantes directe, inverse et/ou homopolaire et assurer une surveillance du circuit électrique, les valeurs exactes n'ont que très peu d'intérêt. Le procédé selon l'invention permet donc de répondre à cette problématique de comparaison de tension entre les phases sans nécessiter de mesure supplémentaire, telle qu'une mesure effectuée sur un circuit basse tension comme cela est le cas dans l'art antérieur. De plus, le gain étant déterminé uniquement en l'absence de défaut électrique du circuit et donc de déséquilibre des phases, les tensions restent exploitables même lors d'une défaillance du circuit. Les gains utilisés ne sont pas affectés par un éventuel défaut, ou dysfonctionnement, électrique du circuit ou du réseau. Ainsi, même dans ces cas, les tensions estimées restent fiables.

Un tel procédé peut être ainsi mis en œuvre dans des applications diverses notamment pour la mesure des tensions triphasées d'un circuit moyenne tension (mesure de tensions, détermination de la phase, détermination des composantes directe, inverse et/ou homopolaire, calcul d'amplitude, de phase...), la détermination de puissances (calcul de puissance active, réactive, apparente, calcul d'énergie dans les quatre quadrants), la détermination de la présence de la moyenne tension (notamment pour activer/inhiber des algorithmes de détection de défauts, de protection...), la détection et l'identification de défauts (détermination de la tension résiduelle pour analyser la nature du défaut, permanent ou fugitif, détection directionnelle du défaut par une détection au plus juste de la tension de polarisation) et la détermination de la fréquence et de la phase de la tension primaire pour optimiser l'échantillonnage.

La portion de période de la tension périodique peut présenter une une durée inférieure à 8 ms, voire 1 ms ou encore 100 $\mu$s. Généralement, la durée de la portion de période peut être choisie comme un ratio de la moitié de la période de la tension protidique. Ainsi, par exemple, pour une tension périodique de fréquence 60 Hz, la moitié de la période de la tension périodique étant d'environ 8ms, la durée de la portion de période peut être de 80 $\mu$s ce qui correspond à un centième de la moitié de la période de la tension périodique, ou de 8 $\mu$s ce qui correspond à un millième de la moitié de la période de la tension périodique.

Le capteur de tension est adapté pour fournir un signal représentatif d'au moins une partie de la période de la tension périodique de ladite phase, la partie de la période de la tension périodique est une partie de période dont la durée est supérieure à celle de la portion de période mesurée pendant l'étape de mesure. Généralement, la partie de période de la tension périodique peut être la moitié de la période de la tension périodique telle qu'en alternance positive.

Par défaut électrique du circuit il doit être entendu ci-dessous et dans le reste de ce document, tout défaut électrique correspondant à un défaut d'au moins l'une des phases par rapport aux autres phases, tel qu'un déséquilibre de phase ou encore un défaut de terre

La sous-étape de détection d'un éventuel défaut électrique peut comporter les opérations suivantes :

- détermination d'au moins une valeur parmi les valeurs de tension maximale et de tension minimale du signal représentatif à partir des variations du signal représentatif mesurées pendant une durée donnée, cette même valeur étant déterminée pour la ou les autres phases du circuit électrique,
- comparaison de ladite valeur avec celles obtenues pour la ou les autres phases, un défaut électrique étant détecté si la valeur obtenue pour l'une des phases diverge vis-à-vis de celle obtenue pour l'autre ou les autres phases du circuit.

Une telle détection de défaut est particulièrement adaptée pour repérer un défaut électrique d'un circuit présentant plusieurs phases. Avec de telles étapes, il est ainsi aisé de détecter un déséquilibre de phase ou encore un défaut de terre.

La sous-étape de calcul du gain si aucun défaut électrique n'est détecté peut comporter les opérations suivantes :

- détermination pendant une durée d'analyse de l'amplitude moyennée du signal représentatif,
- calcul du gain à partir de l'amplitude moyennée pendant la durée d'analyse et de la tension nominale de référence, ce calcul étant préférentiellement réalisé selon l'équation suivante :

$$GX = \frac{Vnom}{\|VXr\|}$$

avec GX le gain, Vnom la tension de référence, $\|VXr\|$ l'amplitude moyennée sur la durée d'analyse

le gain précédent calculé lors d'une étape de détermination précédente étant conservé si un défaut électrique est détecté.

Un tel calcul permet de fournir une tension estimée parfaitement normée, le gain étant basé sur une amplitude moyennée.

L'étape d'estimation peut comprendre la sous-étape suivante :

- application d'un filtre passe-bas au signal représentatif amplifié préférentiellement du type récursif.

Le filtre passe-bas récursif peut comporter les opérations suivantes :

- détection d'une variation du signal représentatif amplifié supérieure à une valeur seuil d'activation, une telle variation étant signature d'un bruit haute fréquence,
- si une variation du signal représentatif amplifié supérieure à la valeur seuil de détection d'un bruit haute fréquence est détectée, estimation de manière récursive du signal représentatif amplifié de manière à atténuer le bruit haute fréquence détecté.

De tels filtres passe-bas permet de fournir une tension estimée exploitable même lorsque le capteur permettant de fournir le signal représentatif est sujet à du bruit haute fréquence. Il est également à noter qu'un filtre récursif est particulièrement avantageux quand le capteur ne permet de fournir un signal représentatif que d'un type d'alternance de la tension périodique à estimer.

Le capteur de tension peut être un capteur adapté pour fournir un signal représentatif d'une portion de période de la tension périodique, et dans lequel l'étape d'estimation comprend la sous-étape de :

- mise à zéro du signal représentatif estimé en dehors de la portion de période représentée par le signal représentatif.

L'étape d'estimation peut comprendre la sous-étape suivante :

- vectorisation du signal représentatif amplifié.

Une telle étape de vectorisation est particulièrement avantageuse pour traiter le signal représentatif afin de compenser d'éventuels déphasages et/ou l'absence dans le signal représentatif d'un type d'alternance de la tension périodique à estimer.

Le capteur de tension peut être un capteur adapté pour fournir un signal représentatif à partir d'un élément dérivatif ou intégratif tel qu'une tension mesurée sur une capacité du circuit électrique et l'étape d'estimation comprenant une sous-étape de :

- déphasage du signal représentatif amplifié de 90°.

L'invention concerne en outre un dispositif d'estimation d'une tension périodique pour estimer une tension d'une phase d'un circuit électrique au moins biphasé, telle qu'une tension d'entrée du circuit électrique, le circuit électrique comportant pour chacune de ses phases un capteur de tension apte à fournir un signal représentatif d'au moins une portion de la tension périodique, tel que défini dans la revendication indépendante 8.

L'unité d'amplification peut comporter un module de filtrage récursif configuré pour appliquer un filtre passe-bas récursif au signal représentatif amplifié.

De tels dispositifs d'estimation permettant la mise en œuvre d'un procédé selon l'invention bénéficient des avantages qui y sont liés.

L'invention concerne en outre un circuit électrique au moins biphasé comportant pour chacune de ses phases un capteur de tension apte à fournir un signal représentatif d'au moins une portion de la tension périodique, comportant un dispositif d'estimation selon l'invention.

Un tel circuit bénéficie des avantages similaires à celui du dispositif d'estimation selon l'invention qui l'équipe.

## BRÈVE DESCRIPTION DES DESSINS

La présente invention sera mieux comprise à la lecture de la description d'exemples de réalisation, donnés à titre purement indicatif et nullement limitatif, en faisant référence aux dessins annexés sur lesquels :

- la figure 1 est un schéma fonctionnel d'un circuit moyenne tension équipé d'un dispositif d'estimation de tension selon l'invention,
- la figure 2 est un schéma fonctionnel de la partie du dispositif d'estimation illustré sur la figure 1 qui forme une unité de mesure d'un signal représentatif d'une tension du circuit moyenne tension,

- la figure 3 est un schéma fonctionnel de la partie du dispositif d'estimation illustré sur la figure 1 qui forme une unité d'amplification du signal représentatif obtenu à partir l'unité de mesure,
- la figure 4 est un ordinogramme illustrant le fonctionnement général de la partie du dispositif illustré sur la figure 1 qui forme une unité d'estimation,
- la figure 5 est un ordinogramme illustrant les sous-étapes d'une première étape de filtrage de l'ordinogramme illustré sur la figure 4,
- la figure 6 est un ordinogramme illustrant les sous-étapes d'une deuxième étape de filtrage de l'ordinogramme de la figure 4,
- la figure 7 est un ordinogramme des opérations de détermination de pente qui sont mis en œuvre lors d'une sous-étape de l'ordinogramme de la figure 6,
- les figures 8A, 8B et 8C illustrent toutes trois la tension de l'une des phases d'un circuit électrique et les différents signaux électriques obtenus lors de la mise en œuvre du procédé d'estimation selon l'invention.

Des parties identiques, similaires ou équivalentes des différentes figures portent les mêmes références numériques de façon à faciliter le passage d'une figure à l'autre.

Les différentes possibilités (variantes et modes de réalisation) doivent être comprises comme n'étant pas exclusives les unes des autres et peuvent se combiner entre elles.

## EXPOSÉ DÉTAILLÉ DE MODES DE RÉALISATION PARTICULIERS

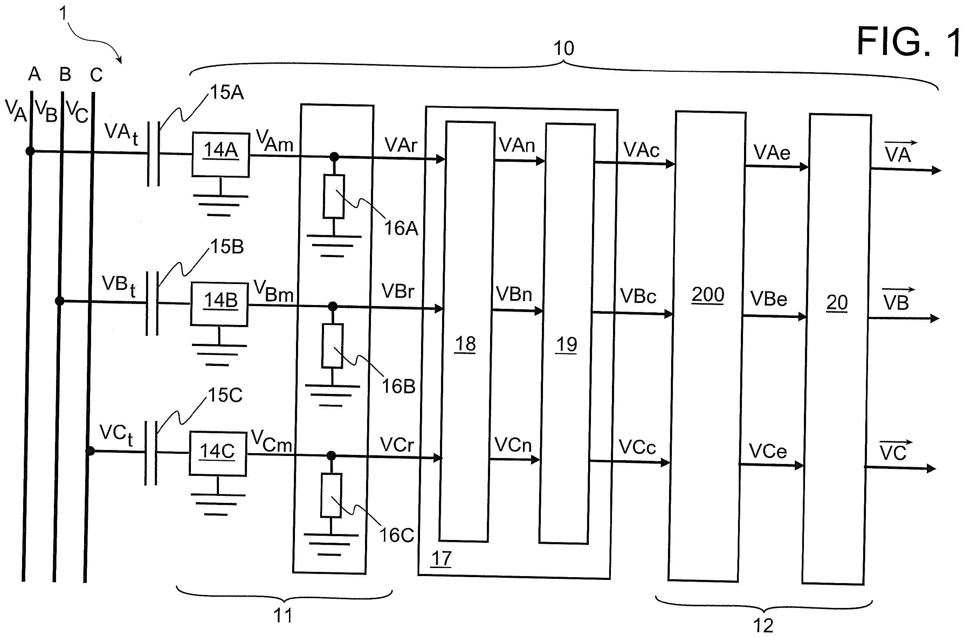

La figure 1 est un schéma fonctionnel d'un circuit électrique triphasé, tel que celui d'un transformateur moyenne tension/basse tension, comprenant un circuit moyenne tension et un circuit basse tension, le circuit basse tension n'étant pas représenté, et un dispositif permettant d'estimer pour chacune des phases une tension du circuit moyenne tension du transformateur.

Le circuit moyenne tension comporte également pour chacune de ses phases, au moins une capacité de traversée 15A, 15B, 15C (également connue sous sa dénomination anglaise de « capacitor bushing ») et un capteur de tension associé à cette dernière tel qu'un indicateur de présence de tension 14A, 14B, 14C (également connue sous sa dénomination anglaise de « Voltage Presence Indicator System » et son sigle anglais « VPIS »).

Il est à noter que pour les références utilisées ci-dessus et dans le reste de ce document, ainsi que pour les variables utilisées par la suite, les indicatifs A, B, C sont utilisés respectivement pour une première, une deuxième et une troisième phase du circuit électrique. Dans le cas où il n'est pas fait renvoi à une phase en particulier les indicatifs A, B, C sont remplacés par l'indicatif X. Ainsi par la suite, dans les références et les variables utilisant l'indicatif X, ce dernier indicatif peut être remplacé par l'un quelconque des indicatifs A, B et C.

L'indicateur de présence de tension 14A, 14B, 14C permet de récupérer un signal représentatif VAm, VBm, VCm représentant les alternances positives de la tension VAt, VBt, VCt aux bornes de la capacité de traversée 15A, 15B, 15C. Ainsi chaque indicateur de présence de tension 14A, 14B, 14C est apte à fournir un signal représentatif VAm, VBm, VCm d'une portion périodique, les alternances positives, de la tension VA, VB VC d'entrée de l'une des phases du circuit moyenne tension. En effet, la tension aux bornes de la capacité de traversée 15A, 15B, 15C correspond à une dérivée de la tension d'entrée VA, VB, VC de la phase correspondante du circuit électrique 1.

Le dispositif d'estimation 10 comporte, comme illustré sur la figure 1 :

- une unité de mesure 11 configurée pour mesurer le signal représentatif mesuré VAm, VBm, VCm d'au moins une portion de la tension VAt, VBt, VCt des capacités de traversée 15A, 15B, 15C à partir de l'indicateur de présence de tension 14A, 14B, 14C correspondant,
- une unité d'amplification 17 configurée pour filtrer et adapter le signal représentatif obtenu par l'unité de mesure 11 pour chacune des phases par un gain GA, GB, GC déterminé pour chacune des phases en l'absence de défaut électrique du circuit électrique 1 et sur la base d'une tension de référence Vnom commune à l'ensemble des phases du circuit électrique 1,
- une unité d'estimation 12 configurée pour estimer la tension VA, VB, VC à partir du signal représentatif amplifié VAc, VBc, VCc de la tension fourni par l'unité d'amplification 17.

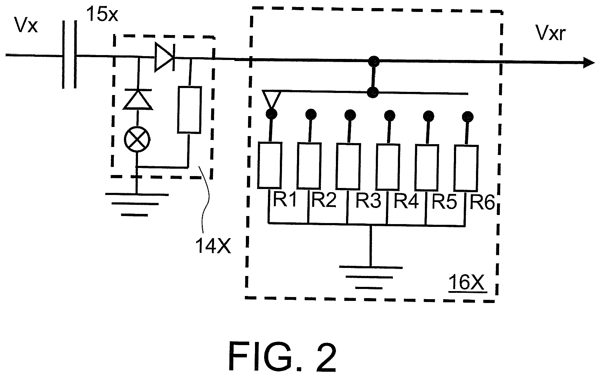

En référence à la figure 2, l'unité de mesure 11 comporte :

- un indicateur de présence de tension 14A, 14B, 14C pour chacune des phases,
- un système de résistance d'adaptation 16A, 16B, 16C, illustré sur la figure 2, pour chacune des phases,

Chaque système de résistance d'adaptation 16A, 16B, 16C permet d'adapter la valeur de résistance par le choix de l'une des résistances parmi les résistances disponibles, ici les six résistances R1, R2, R3, R4, R5 et R6, de telle manière que lors de l'initialisation de l'indicateur de présence de tension 14A, 14B, 14C, correspondant, le signal représentatif VAr, VBr, VCr fourni en sortie de ce dernier soit au plus près de la valeur attendue de la tension de référence Vnom. Typiquement, le signal représentatif VAr, VBr, VCr est considéré comme près de la valeur attendue de la tension de référence Vnom quand son amplitude est comprise entre la moitié et le double de l'amplitude de la tension à estimer.

Ainsi l'unité de mesure 11 permet de fournir pour chacune des phases un signal représentatif VAr, VBr, VCr d'une tension du circuit électrique 1 moyenne tension à partir des indicateurs de présence de tension 14A, 14B, 14C. Le signal représentatif VAr, VBr, VCr est ensuite transmis à l'unité d'amplification 17.

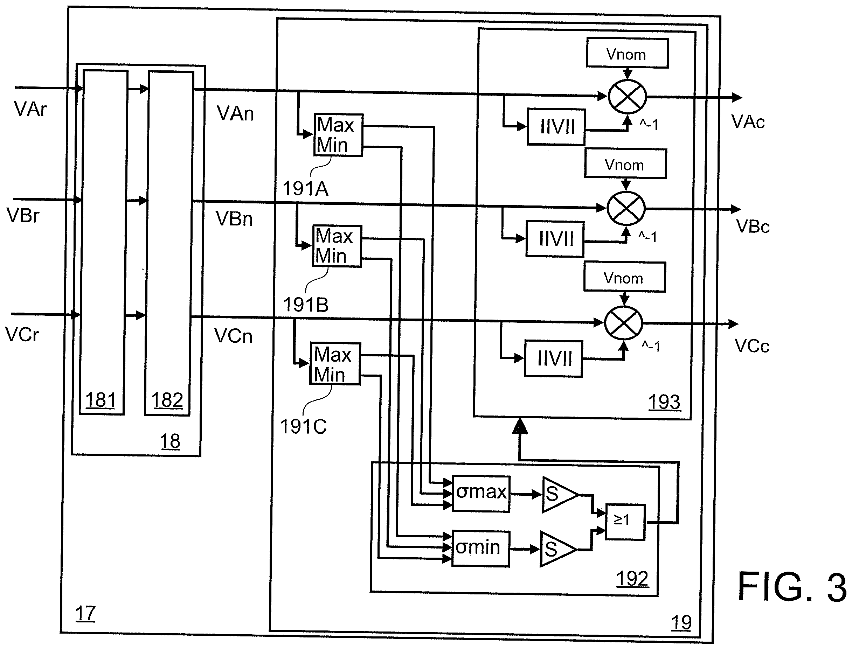

En référence à la figure 3, l'unité d'amplification 17 comporte :

- un filtre passe bas 181,
- un convertisseur numérique-analogique 182, le filtre passe bas 181 et le convertisseur numérique analogique 182 étant fournis sous la forme d'un sous module de numérisation 18,
- pour chacune des phases, un élément de détermination 191A, 191B, 191C de la tension maximale VAmax, VBmax, VCmax et de la tension minimale VAmin, VBmin, VCmin du signal représentatif numérisé VAn, VBn, VCn,
- un système de détection 192 de défaut du circuit électrique configuré pour déterminer à partir des tensions maximales VAmax, VBmax, VCmax et minimales VAmin, VBmin, VCmin la présence d'un éventuel défaut du circuit électrique,
- un système de calcul 193 configuré pour calculer pour chacune des phases et à partir des mesures moyennées des amplitudes de tensions ∥VAr∥, ∥VBr∥ et ∥VCr∥ et d'une tension de référence Vnom un gain GA, GB, GC en l'absence de défaut du circuit électrique 1, ledit système de calcul 193 étant également adapté pour appliquer pour chacune des phases le gain GA, GB, GC au signal de représentatif numérisé correspondant de manière à fournir un signal représentatif amplifié VAc, VBc, VCc.

Dans la configuration illustrée sur la figure 3, les éléments de détermination 191A, 191B, 191C, le système de détection 192 et le système de calcul sont arrangés sous la forme d'un module d'amplification 19.

Ainsi, le signal représentatif fourni par le système de résistance d'adaptation 16A, 16B, 16C est ensuite filtré par le filtre passe-bas 181 de manière à éliminer du signal représentatif les fréquences supérieures à 0,5 fois la fréquence d'échantillonnage du convertisseur numérique-analogique 182.

Le signal représentatif ainsi numérisé VAn, VBn, VCn par le convertisseur numérique-analogique 182 est ensuite transmis au module d'amplification 19.

Les éléments de détermination 191A, 191B, 191C analysent le signal représentatif numérisé VAn, VBn, VCn pendant une durée d'analyse de manière à déterminer pendant la durée d'analyse les tensions maximales VAmax, VBmax, VCmax et minimales VAmin, VBmin, VCmin atteintes par le signal représentatif VAr, VBr, VCr. Les tensions maximales VAmax, VBmax, VCmax et minimales VAmin, VBmin, VCmin ainsi déterminées sont transmises au système de détection 192 de défaut du circuit électrique. Typiquement, la durée d'analyse est choisie de manière à couvrir un nombre significatif de périodes du signal représentatif, généralement une durée d'analyse d'une seconde convient parfaitement.

Le système de détection 192 est configuré pour comparer les tensions maximales VAmax, VBmax, VCmax obtenues pour chacune des phases du circuit et ainsi détecter un éventuel déséquilibre de la tension des phases. Ce même système de détection permet également de comparer les tensions minimales VAmin, VBmin, VCmin obtenues pour chacune des phases du circuit et ainsi détecter un éventuel déséquilibre de la tension des phases. Un tel déséquilibre, que ce soit au niveau des tensions maximales VAmax, VBmax, VCmax ou des tensions minimales VAmin, VBmin, VCmin, est effectivement représentatif d'une signature d'un défaut, ou dysfonctionnement, du circuit électrique, tel qu'un défaut de terre ou une tension résiduelle non nulle.

Par exemple, une telle comparaison peut être effectuée en vérifiant si les trois tensions maximales VAmax, VBmax, VCmax présentent un écart inférieur à 10% vis-vis de la moyenne de ces trois mêmes tensions, tout écart supérieur étant identifié comme signature d'un défaut électrique du circuit.

Toute détection d'un défaut électrique par le système de détection 192 est transmise au système de calcul 193.

De cette manière, en cas de détection d'un défaut électrique du circuit par le système de détection 192, les gains GA, GB, GC ne sont pas recalculés sur la base d'amplitudes respectives moyennées ∥VAr∥, ∥VBr∥ et ∥VCr∥ pour lesquelles un défaut a été détecté sur la base des tensions VAmax, VBmax, VCmax, VAmin, VBmin, VCmin. ; la valeur précédente du gain GA, GB,GC étant alors conservée pour chacune des phases.

A contrario, dans le cas où le système de détection 192 ne détecte pas de défaut électrique du circuit électrique 1, le système de calcul 193 calcule le gain GA, GB, GC pour chacune des phases. Ce calcul se fait, comme illustré sur la figure 3, sur la base de l'équation suivante :

$$(1) \qquad GX = \frac{Vnom}{\|VXr\|}$$

avec GX le gain pour la phase donnée, ‖VXr‖ l'amplitude moyennée sur la durée d'analyse, Vnom la tension de référence.

Un tel calcul du gain GA, GB, GC pour chacune des phases n'a pas à être réalisé continûment. En effet, si les capacités 15A, 15B, 15C peuvent voir leur valeur fluctuer dans le temps en raison de variations de température et de leur vieillissement, cette fluctuation est lente. Ainsi, selon une possibilité de l'invention, le calcul des gains GA, GB, GC peut être réalisé régulièrement, par exemple une fois par heure.

Bien entendu, la détection de défaut électrique du circuit peut être réalisée soit uniquement lors du calcul des gains GA, GB et GC, ou de manière continue, ou encore régulièrement avec une fréquence supérieure à celle du calcul des gains GA, GB, GC, étant entendu qu'une détection de défaut a lieu lors du calcul des gains GA, GB et GC. Selon cette possibilité pour laquelle le calcul des gains GA, GB, GC est réalisé régulièrement et non continûment, les valeurs de gains GA, GB, GC sont conservées entre deux calculs de la même manière que lorsqu'un défaut électrique du circuit est détecté.

L'unité de calcul permet, à partir des gains GA, GB, GC ainsi déteminés, d'amplifier le signal représentatif numérisé VAn, VBn, VCn en appliquant l'équation d'amplification suivante :

$$(2) \qquad VXc = GX \times VXn$$

avec VXc le signal représentatif amplifié d'une phase, GX le gain correspondant à cette même phase et VXn le signal représentatif numérisé de cette phase.

Le signal représentatif ainsi amplifié VAc, VBc, VCc présente une amplitude normée au moyen de la tension de référence Vnom. Cette tension de référence Vnom étant commune à l'ensemble des phases et les gains GA, GB, GC étant calculés en l'absence de défaut électrique, les signaux représentatifs amplifiés VAc, VBc, VCc sont équilibrés entre eux avec une amplitude sensiblement égale.

Le signal représentatif amplifié VAc, VBc, VCc est transmis en sortie du module d'amplification 19 et est ensuite transmis à l'unité d'estimation 12.

En référence à la figure 1, l'unité d'estimation 12 comporte :

- un module de filtrage récursif 200, et
- un module de vectorisation 20.

Le module de filtrage récursif 200 est configuré pour limiter le bruit de haute fréquence présent sur le signal représentatif amplifié et peut être également dénommé filtre passe-bas récursif.

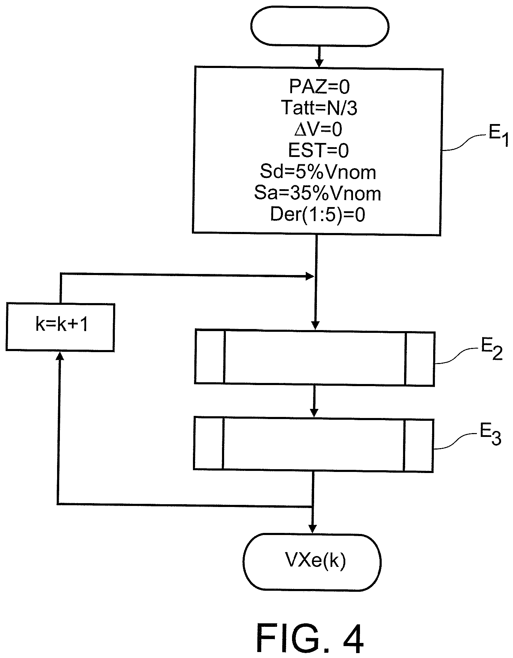

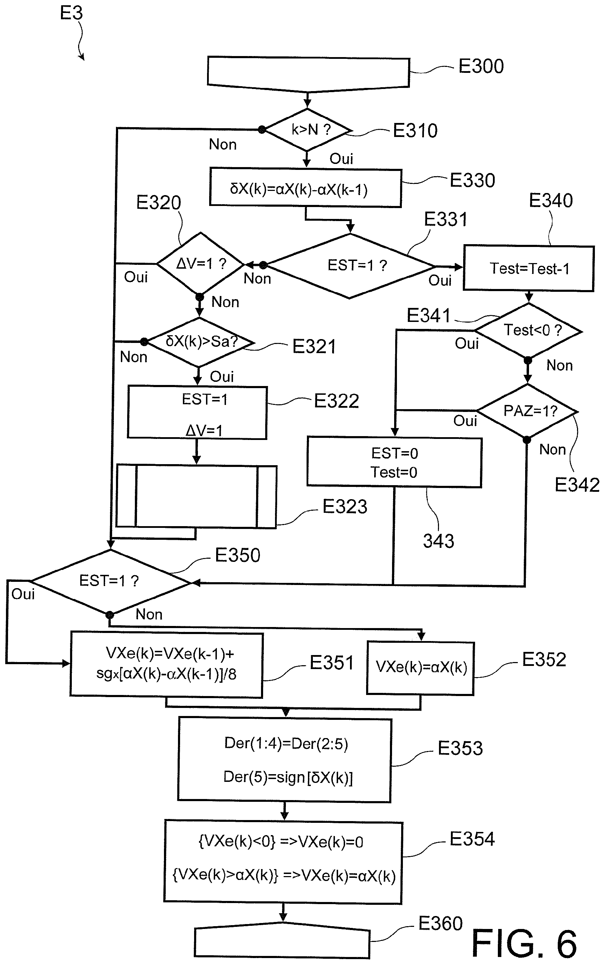

Le module de filtrage récursif 200 fonctionne suivant le procédé illustré par les ordinogrammes des figures 4, 5 et 6.

Ainsi, comme illustré sur la figure 4, le module de filtrage récursif 200 est configuré pour répéter à chaque incrément temporel et à partir du signal représentatif amplifié, après une étape d'initialisation E1 du procédé, les étapes générales suivantes :

- une étape de détection E2 de la fin des portions de période correspondant aux alternances positives, par une détection d'un passage à zéro décroissant, et de mise à zéro des portions de période correspondant aux alternances négatives,
- et une étape de filtrage récursif E3 en tant que tel.

Lors de l'étape d'initialisation E1 du procédé, les paramètres suivants du procédé sont initialisés :

- PAZ, une variable d'état qui prend la valeur 1 si un passage à zéro décroissant a été détecté, est mise à 0,
- Tatt, un temps d'attente pendant lequel après le début d'une alternance positive du signal représentatif amplifié, la détection d'un passage à zéro est désactivée, cette variable étant ici fixée à un tiers de période N,
- ΔV, variable d'état d'une détection de la variation du signal représentatif amplifié VAc, VBc, VCc, cette variable étant mise à 1 lorsqu'une variation du signal représentatif amplifié VAc, VBc, VCc est détectée, est mise à 0,
- EST, variable d'état d'activation de l'estimation du signal représentatif amplifié, cette variable prenant la valeur 1 lorsque l'estimation est activée, est mise à 0,
- Sd, constante fixant le seuil de détection pour la détection du prochain passage à zéro décroissant, cette constante peut être par exemple être fixée à 5% de la tension de référence Vnom,
- Sa, constante fixant le seuil d'activation de l'estimation, Sa étant une valeur de seuil d'activation à partir de laquelle une variation du signal amplifié est considérée comme signature de la détection d'un bruit haute fréquence qui doit être filtré, cette constante peut être par exemple fixée à 35% de la tension de référence Vnom,
- Der(1) à Der(5), les valeurs d'état d'un tableau glissant d'état des 5 derniers signes de la variation d'une valeur tampon δX(k) obtenues pour les itérations k à k-4, sont mises à 0.

Il est à noter que le procédé met également en œuvre trois autres variables qui ne sont pas initialisées lors de l'étape d'initialisation E1:

- k, un incrément temporel, représentant la variable temporelle avec kxN qui est égale à la période de la tension à estimer, N étant le nombre d'échantillons par période de la tension à estimer,
- αX(k) qui est une valeur tampon dans laquelle est reporté le signal représentatif amplifié VAc, VBc, VCc ou forcé à 0,
- daX qui représente la variation moyenne du signal représentatif amplifié VAc, VBc, VCc sur la durée de deux incréments temporels,
- Tzero qui est une variable temporelle qui permet de forcer les échantillons à zéro après la détection d'un passage à zéro décroissant,
- Test qui est une variable temporelle qui permet de fixer la durée pendant laquelle l'estimation est activée,
- VXe(k) qui est la valeur du signal représentatif estimé,
- δX(k) qui est la variation de la valeur tampon αX(k) à l'itération k qui est calculée entre l'itération k et l'itération k-1,
- sg est une variable d'état de la pente moyenne du signal représentatif, celle-ci prenant la valeur +1 pour une pente croissante et la valeur -1 pour une pente décroissante,
- p et n sont respectivement des variables de nombre de variations positives et négatives obtenues lors des 5 dernières itérations sur la base du tableau glissant Der(1) à Der(5)

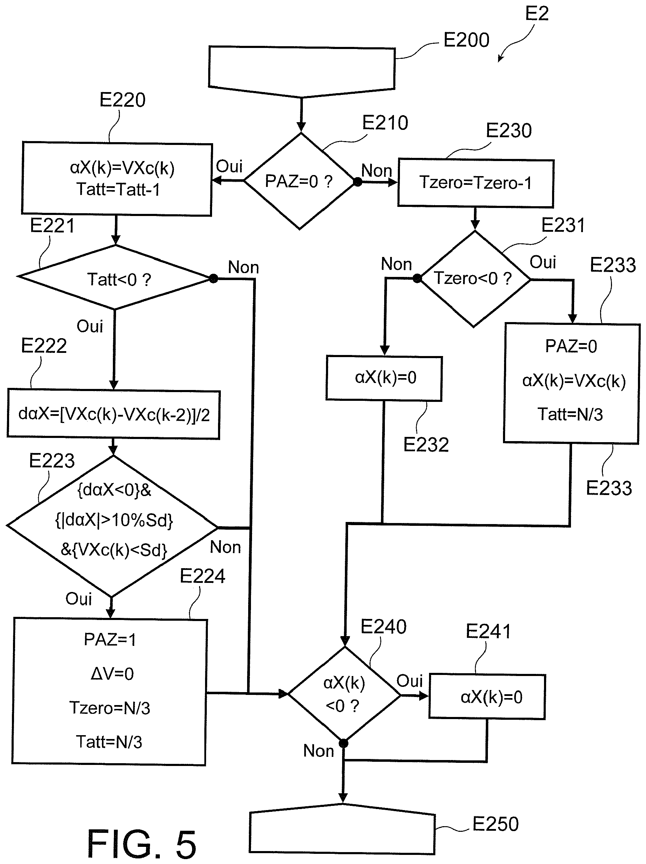

La figure 5 est un ordinogramme illustrant l'enchainement des sous-étapes de l'étape de détection E2. Ainsi, l'étape de détection E2 comporte les sous-étapes et opérations suivantes :

- E210 vérification si un passage à zéro décroissant n'a pas préalablement été détecté ceci en vérifiant l'état de la variable d'état PAZ,
- E220 si la variable d'état PAZ est à 0 et donc qu'aucun passage à zéro décroissant n'a été détecté, fixation de la valeur tampon de détection αx(k) à la valeur du signal VXc(k) avec l'équation suivante αX(k)= VXc(k), et décrémentation du temps d'attente Tatt ;
- E221 vérification si le temps d'attente Tatt est inférieur à 0,
- E222) si le temps d'attente Tatt est inférieur à 0, c'est-à-dire que le début d'une alternance négative a été détecté il y a plus de deux tiers de période, calcul de la variation moyenne du signal représentatif dax(k) selon l'équation

$$daX = \frac{(VXc(k) - VXc(k-2))}{2},$$

- E223 détection d'un passage à zéro décroissant en vérifiant si les inéquations suivantes sont vérifiées : daX<0 et |daX|> (10%xSd) et VXc(k)<Sd,
- E224 si un passage à zéro décroissant est détecté à la sous-étape E223, initialisation de PAZ à 1 et de ΔV à 0, Tzero et Tatt étant fixés à N/3,
- E240 vérification du signe de la valeur αX(k),
- E250 si αX(k) est nulle ou de signe positif, passage à l'étape de filtrage récursive E3,
- si en E221 la variable Tatt est supérieure à 0, passer directement en E240 sans passer par E222 à E224,
- de même si en E223, au moins l'une des inéquations n'est pas vérifiée, un passage à zéro décroissant n'est pas détecté et il est passé directement en E240,
- si en E210, l'état de la valeur d'état PAZ n'est pas à 0 et donc qu'un passage à zéro décroissant a préalablement été détecté, E230 décrémentation de 1 de la variable Tzero,
- E231 vérification qu'un passage à zéro a été détecté il y a moins d'un tiers de période en vérifiant que Tzéro est positif,
- E232, si Tzero est positif, mise à 0 de la variable αx(k),
- si Tzero est négatif en E231), E233) initialisation de la variable d'état PAZ à 0, report de la valeur de VXc(k) dans la variable αX(k), et fixation de Tatt à N/3,
- après E232 et E233, passage en E240.

De cette manière les valeurs de VXc(k) sont reportées dans αX(k) lorsque le signal représentatif est en alternance positive (E220 à E224) et αX(k) est mis à 0 lorsque l'on se trouve dans une alternance négative (E232) avec dans les deux cas une élimination des valeurs négatives de VXc(k) (E240 et E241), ces valeurs étant nécessairement liées au bruit de l'indicateur de présence de tension 14A, 14B, 14C.

L'étape de filtrage E3 récursif comprend les sous-étapes suivantes et opérations de :

- E310 vérification si une première initialisation de l'étape filtrage a déjà eu lieu en vérifiant que k est supérieur à N, c'est-à-dire qu'une première période du signal représentatif a déjà été filtrée,

- si la première initialisation n'a pas encore eu lieu, E350 vérification de l'état de la variable d'état de EST,
- si l'état de la variable d'état EST est égal à 1, E351, estimation de la valeur estimée VXe(k) du signal représentatif à partir de cette même valeur VXe(k) obtenue à l'itération précédente, de la variable d'état de la pente moyenne du signal représentatif sg et la variation de la valeur tampon entre l'itération actuelle αX(k) et l'itération précédente

$$VXe(k) = VXe(k-1) + sg \times \frac{(\alpha X(k) - \alpha X(k-1))}{8})$$ ,

αX(k-1) au moyen de l'équation suivante

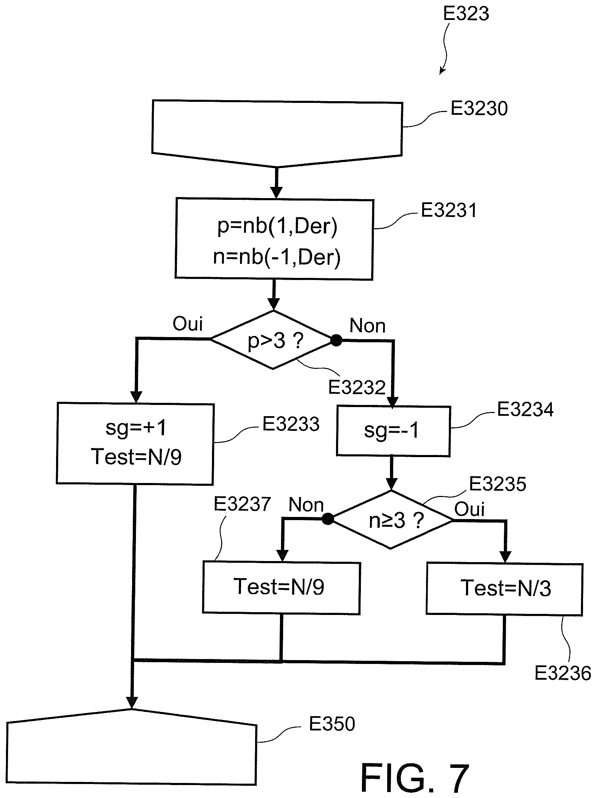

- E353 glissement des valeurs du tableau Der, avec les états Der(1:4) qui sont descendues d'une itération pour être reportés à Der(2:5), le signe de la variation de la valeur tampon étant reporté à Der(5),
- E354, correction des valeurs estimées ceci en vérifiant si la valeur estimé VXe(k) est positive, la valeur étant alors mise à 0 si elle n'est pas positive, et en vérifiant que la valeur estimée VXe(k) n'est pas supérieure à la valeur tampon αx(k), la valeur tampon étant reportée dans la valeur estimée VXe(k) si cette dernière est supérieure à la valeur tampon αX(k),
- E360 transmission de la valeur estimée VXe(k) au module de vectorisation 20,
- si à l'étape E310, la première d'initialisation de l'étape filtrage a déjà eu lieu, E330 réalisation d'un calcul de la variation de la valeur tampon αX(k) entre l'itération k et l'itération k-1 au moyen de l'équation suivante, δX(k)=αX(k)-αX(k-1),
- E331 vérification de l'état de la variable d'état EST,
- si l'état de la variable d'état EST est nulle, E320 vérification de l'état la variable d'état ΔV,
- si l'état de la variable d'état ΔV est égal à 1, passage à l'étape E350,
- si à l'étape E320, la variable d'état ΔV est nulle, E321 vérification que la valeur de variation δX(k) de la valeur tampon à l'itération k est supérieure au seuil d'activation Sa,
- si la valeur de variation δX(k) de la valeur tampon à l'itération k est inférieure ou égale au seuil d'activation, passage à l'étape E350,
- si la valeur de variation δX(k) de la valeur tampon à l'itération k est en E321 supérieure au seuil d'activation Sa, E322 passage des variables d'état EST et ΔV à l'état 1,
- E323 sous-étape de détermination de la variable d'état sg de la pente moyenne du signal représentatif et de la variable temporelle Test qui permet de fixer la durée pendant laquelle l'estimation est activée en suivant les opérations illustrées sur l'ordinogramme de la figure 7,
- Passage en E350,
- Si en E331 la variable d'état EST est à l'état 1, E340 décrémentation de 1 la variable temporelle Test,
- E341 vérification si la variable temporelle Test est passée à une valeur négative,
- Si la variable temporelle Test est passée à une valeur négative, E343 passage de la variable d'état EST à 0 et mise à 0 de la variable temporelle Test, puis passage en E350,
- Si la variable temporelle Test est supérieure ou égale à 0 en E341, E342 vérifier qu'un passage à zéro décroissant n'a pas été détecté en contrôlant que la variable d'état PAZ est à 1,
- si la variable d'état PAZ est égale à 1, passage en E343,
- si la variable d'état PAZ est nulle en E342 passage en E350,
- si en E350) la variable d'état EST est nulle, passage en E352 pour report de la valeur tampon αX(k) dans la valeur estimée VXe(k), puis passage en E353.

Ainsi, avec une telle étape de filtrage récursif, le signal représentatif estimé obtenu est nettoyé, puisque les portions du signal représentatif correspondant aux alternances négatives sont mises à zéro, et présente un bruit haute fréquence réduit grâce à l'estimation récursive de la sous-étape E351 qui est effectuée en cas de détection d'une forte variation de tension par la sous-étape E320 supérieure au seuil d'activation Sa, une telle variation étant signature d'un bruit haute fréquence.

La sous-étape E323 permet de déterminer le signe de la pente et de définir la fenêtre temporelle Test pendant laquelle l'estimation récursive de l'étape E351 est appliquée.

Une telle sous-étape E323 comporte les opérations suivantes :

- E3231 calcul des variables p et n à partir du tableau glissant Der(1:5), p étant le nombre de cases du tableau Der(1:5) présentant la valeur 1, n étant le nombre de cases du tableau Der(1:5) présentant la valeur -1,
- E3232 détermination de la présence d'une pente positive, une pente positive étant détectée si p est strictement supérieur à 3,
- E3233 si une pente positive est détectée, passage de la variable d'état Sg à +1 et de la variable temporelle Test à N/9,
- E350 Passage à la sous-étape suivante de l'étape E3, à savoir en E350,

- si en E3231 aucune pente positive n'est détectée, c'est-à-dire que p est supérieur ou égal à 3, E3234 passage de la variable d'état sg à -1,
- E3235 détection d'une pente négative en déterminant si la variable n est supérieure ou égale à 3,
- si aucune pente négative n'est détectée et donc que n est égal 2, passage de la variable temporelle Test à N/9, puis passage à la sous-étape suivante de l'étape E3, à savoir en E350,
- si en E3234 une pente négative est détectée, c'est-à-dire que la variable n est supérieure ou égale à 3, E3236 passage de la variable temporelle Test à N/3, puis passage à la sous-étape suivante de l'étape E3, à savoir en E350.

De cette manière la fenêtre d'estimation pendant laquelle le signal représentatif est estimé est variée en fonction de la pente, celle-ci étant fixée à un neuvième de période en pente montante (p>3) et avec une faible pente (p=3 et n=2) et à un tiers de période en cas de pente négative (n≥3).

Le signal représentatif après estimation par le module de filtrage récursif 200, est transmis au module de vectorisation 20.

Le module de vectorisation 20 est configuré pour appliquer au signal représentatif estimé VAe, VBe, VCe une transformée de Fourier Discrète, également connue sous le sigle TFD, afin d'obtenir une représentation vectorielle dans l'espace fréquentiel.

Le module de vectorisation 20 est également configuré pour effectuer un décalage de phase du signal représentatif vectorisé $\overrightarrow{VAe}, \overrightarrow{VBe}, \overrightarrow{VCe}$ de manière à compenser le décalage de phase apporté par le fait que les signaux représentatifs VAr, VBr, VCr, ont été mesurés sur des capacités de traversée 15A, 15B, 15C. De même le module de vectorisation 20 est également configuré pour compenser le fait que le signal représentatif mesuré ne comporte que les alternances positives du signal à estimer. Un tel décalage de phase et une telle compensation de la perte des alternances négatives sont réalisés en effectuant la transformation vectorielle suivante :

$$ (3) \qquad \overrightarrow{VX} = 2 \times e^{-j \times \frac{\pi}{2}} \times \overrightarrow{VXe} $$

C'est à dire

$$ \overrightarrow{VX} = 2 \times (\mathrm{Im}(\overrightarrow{Vxe}) - j \times \mathrm{Re}(\overrightarrow{VXe})) $$

Ainsi le module de vectorisation 20 permet de fournir une image vectorielle de la tension du circuit électrique 1 pour chacune des phases.

Selon une variante de l'invention dans laquelle le module de vectorisation permet également d'effectuer un filtrage passe-bas supplémentaire, le module de vectorisation 20 peut, après vectorisation du signal représentatif en variante au décalage de phase et de la prise en compte du caractère mono-alternance, effectuer le calcul suivant :

$$ (4) \qquad \overrightarrow{VX} = \overrightarrow{VXe} + 2 \times \overrightarrow{VXe_{-\pi/2}} + \overrightarrow{VXe_{-\pi}} $$

Avec $\overrightarrow{VXe}$ le signal représentatif vectorisé à instant donné, $\overrightarrow{VXe_{-\pi/2}}$ le signal représentatif vectorisé décalé d'un quart de période et $\overrightarrow{VXe_{-\pi}}$ le signal représentatif vectorisé décalé d'une demi-période du signal représentatif.

Ainsi un tel dispositif d'estimation d'une tension permet d'estimer une tension de l'une des phases du circuit. Une telle estimation se fait selon le procédé d'estimation comportant les étapes, les sous-étapes et les opérations suivantes :

- mesure d'un signal représentatif VAm, VBm, VCm d'une tension de la phase du circuit, ici une tension fournie par l'indicateur de présence de tension,
- adaptation du signal représentatif mesuré VAm, VBm, VCm au moyen des résistances R1, R2, R3, R4, R5, du système de résistances d'adaptation 16A, 16B, 16D,
- numérisation et amplification du signal représentatif à partir du signal représentatif adapté VAr, VBr, VCr à partir d'un gain GA, GB, GC déterminé en l'absence de défaut électrique du circuit et sur la base de la tension de référence Vnom commune pour l'ensemble des phases,
- nettoyage du signal représentatif amplifié VAr, VBr, VCr de manière à fournir une mise à zéro du signal représentatif amplifié en dehors des alternances positives de la tension aux bornes de la capacité de traversée 15A, 15B, 15C correspondante,

- estimation du signal représentatif au moyen d'un filtre récursif, ledit filtre étant adapté pour atténuer de manière récursive du bruit haute fréquence lors de sa détection,
- vectorisation du signal représentatif estimé,
- déphasage du signal représentatif estimé de -90° et amplification d'un facteur 2.

Lors de l'étape estimation du signal représentatif au moyen d'un filtre récursif il est prévu les opérations suivantes :

- détection d'une variation du signal représentatif amplifié supérieure à un seuil d'activation, une telle variation étant signature d'un bruit haute fréquence,
- estimation de manière récursive du signal représentatif amplifié de manière à atténuer le bruit haute fréquence lorsqu'une variation du signal représentatif amplifié supérieure à un seuil d'activation a été détectée.

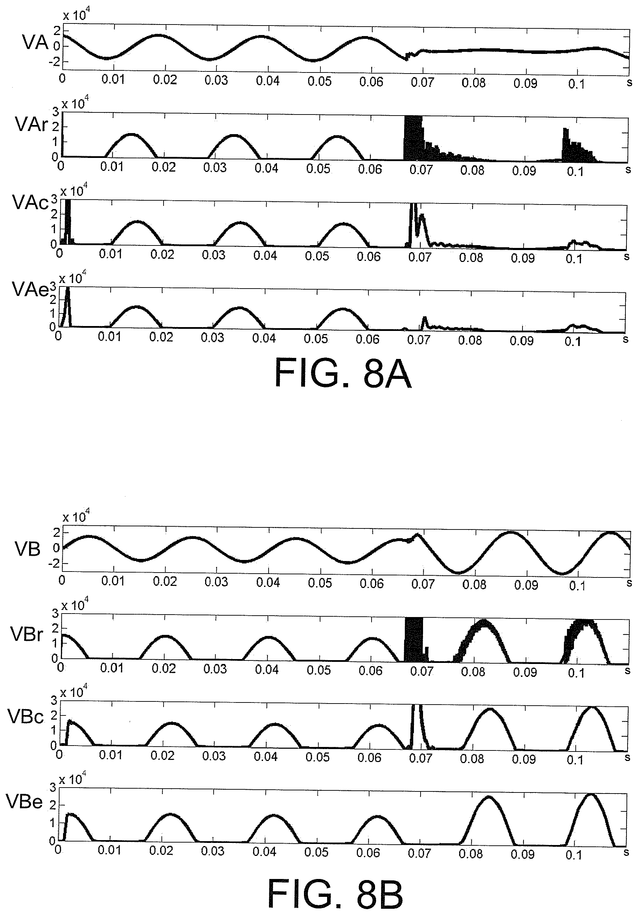

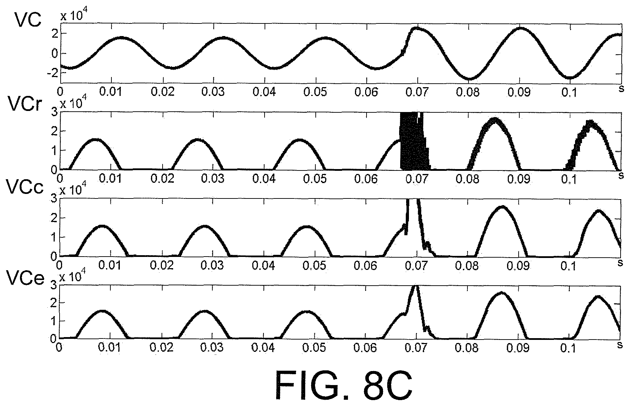

Les figures 8A à 8C illustrent pour respectivement la première, la deuxième et la troisième phase du circuit électrique :

- la tension d'entrée VA, VB, VC du circuit moyenne tension,
- le signal représentatif adapté VAr, VBr, VCr,
- le signal représentatif amplifié VAc, VBc, VCc, et
- le signal représentatif estimé VAe, VBe, VCe.

Sur ces figures, la première partie avant 0,67s représente une situation dans laquelle le circuit électrique 1 est sain et ne présente pas de défaut électrique tandis que la deuxième partie, après 0,67s, représente une situation dans laquelle le circuit présente un défaut phase-terre sur la première phase notamment illustré sur la figure 8A.

On peut ainsi voir qu'en l'absence de défaut, la normalisation du signal représentatif permet d'estimer des tensions pour les phases qui sont parfaitement comparables entre elles et représentatives des tensions réelles appliquées au circuit électrique 1. De même, les tensions estimées en présence du défaut sur la première phase permettent d'identifier le défaut, l'estimation permettant de fournir des tensions représentatives de la situation malgré la survenue du défaut.

Bien entendu, si dans le mode de réalisation décrit ci-dessus, le capteur de tension est un indicateur de présence de tension 14A, 14B, 14C, l'invention peut être appliquée à d'autre type de capteur de tension. Ainsi, en variante, les capacités de traversée 15A, 15B, 15C peuvent chacune être équipée d'un capteur de tension de type Prise de Potentiel à Connectique Séparable, connu sous le sigle PPACS.

Selon cette variante, un tel capteur donnant accès aux deux alternances de la tension de la capacité de traversée 15A, 15B, 15C équipée, le dispositif d'estimation et le procédé d'estimation sont adaptés. Ainsi, avec une telle variante de l'invention, l'unité d'estimation 12, ainsi que l'opération de décalage de phase du module de vectorisation 20 ne sont pas nécessaires.

## Revendications

1. Procédé d'estimation d'une tension périodique, telle qu'une tension d'entrée, de l'une des phases d'un circuit électrique au moins biphasé comportant pour chacune de ses phases un capteur de tension, chaque capteur de tension étant apte à fournir un signal représentatif (VAr, VBr, VCr) d'au moins une partie de période de la tension périodique (VA, VB, VC) de ladite phase, le procédé étant **caractérisé en ce qu'**il comporte les étapes suivantes de :

   - mesure du signal représentatif (VAr,VBr,VCr) d'au moins une portion de période de la tension périodique de la phase à partir du capteur de tension, l'au moins une portion de période ayant une durée inférieure à la partie de période et étant incluse dans ladite partie de période,
   - amplification du signal représentatif (VAr,VBr,VCr) par un gain (GA, GB, GC) déterminé en l'absence de défaut électrique du circuit électrique (1) et sur la base d'une tension de référence (Vnom) commune à l'ensemble des phases du circuit électrique (1),
   - vectorisation du signal représentatif amplifié (VAc, VBc, VCc) de la tension périodique (VA,VB,VC),
   - estimation à partir du signal représentatif amplifié (VAc, VBc, VCc) de la tension périodique (VA,VB,VC) vectorisé pour fournir une image vectorielle de ladite tension périodique (VA, VB,VC),
   dans lequel il est prévu une étape de détermination du gain (GA,GB,GC), ladite étape comportant toutes les n itérations, n étant un entier positif supérieur à 1, les sous-étapes suivantes :
   - détection d'un éventuel défaut électrique,

- si aucun défaut électrique n'est détecté, calcul du gain (GA,GB,GC) sur la base du signal représentatif (VAr,VBr,VCr) et de la tension de référence (Vnom), un gain (GA,GB,GC) calculé lors d'une étape de détermination précédente étant conservé si un défaut électrique est détecté.

2. Procédé d'estimation selon la revendication 1, dans lequel la sous-étape de détection d'un éventuel défaut électrique comporte les opérations suivantes :

- détermination d'au moins une valeur parmi les valeurs de tension maximale (VAmax,VBmax,VCmax) et de tension minimale (VAmin,VBmin,VCmin) du signal représentatif à partir des variations du signal représentatif mesurées (VAm,VBm,VCm) pendant une durée donnée, cette même valeur étant déterminée pour la ou les autres phases du circuit électrique,
- comparaison de ladite valeur avec celles obtenues pour la ou les autres phases, un défaut électrique étant détecté si la valeur obtenue pour l'une des phases diverge vis-à-vis de celle obtenue pour l'autre ou les autres phases du circuit.

3. Procédé d'estimation selon la revendication 1 ou 2, dans lequel, la sous-étape de calcul du gain (GA, GB, GC) si aucun défaut électrique n'est détecté comporte les opérations suivantes :

- détermination pendant une durée d'analyse de l'amplitude moyennée ($\|VAr\|$, $\|VBr\|$, $\|VCr\|$) du signal représentatif (VAr, VBr, VCr),
- calcul du gain (GA, GB, GC) à partir de l'amplitude moyennée ($\|VAr\|$, $\|VBr\|$, $\|VCr\|$) pendant la durée d'analyse et de la tension nominale de référence (Vnom), ce calcul étant préférentiellement réalisé selon l'équation suivante :

$$GX = \frac{Vnom}{\|VXr\|}$$

avec GX le gain, Vnom la tension de référence, $\|VXr\|$ l'amplitude moyennée sur la durée d'analyse

le gain (GA, GB, GC) précédent calculé lors d'une étape de détermination précédente étant conservé si un défaut électrique est détecté.

4. Procédé selon l'une quelconque des revendications 1 à 3 dans lequel l'étape d'estimation comprend la sous-étape suivante :

- application d'un filtre passe-bas au signal représentatif amplifié (VAc, VBc, VCc) préférentiellement du type récursif.

5. Procédé selon la revendication 4, dans lequel le filtre passe-bas récursif comporte les opérations suivantes :

- détection d'une variation du signal représentatif amplifié (VAc, VBc, VCc) supérieure à une valeur seuil d'activation (Sa), une telle variation étant signature d'un bruit haute fréquence,
- si une variation du signal représentatif amplifié (VAc, VBc, VCc) supérieure à la valeur seuil (Sa) de détection d'un bruit haute fréquence est détectée, estimation de manière récursive le signal représentatif amplifié (VAc, VBc, VCc) de manière à atténuer le bruit haute fréquence détecté.

6. Procédé selon l'une quelconque des revendications 1 à 5, dans lequel le capteur de tension est un capteur adapté pour fournir un signal représentatif d'une partie de période de la tension périodique, et dans lequel l'étape d'estimation comprend la sous-étape de :

- mise à zéro du signal représentatif estimé (VAe, VBe, VCe) en dehors de la partie de période représentée par le signal représentatif (VAr, VBr, VCr).

7. Procédé selon l'une quelconque des revendications 1 à 6, dans lequel le capteur de tension est un capteur adapté pour fournir un signal représentatif à partir d'un élément dérivatif ou intégratif tel qu'une tension mesurée sur une capacité (15A, 15B, 15C) du circuit électrique et dans lequel l'étape d'estimation comprend une sous-étape de :

- déphasage du signal représentatif amplifié (VAc, VBc, VCc) de 90°.

8. Dispositif d'estimation (10) d'une tension périodique pour estimer une tension d'une phase d'un circuit électrique (1) au moins biphasé, telle qu'une tension d'entrée du circuit électrique (VA, VB, VC), le circuit électrique (1) comportant pour chacune de ses phases un capteur de tension apte à fournir un signal représentatif (Var, VBr, VCr) d'au moins une partie de la tension périodique,
le dispositif d'estimation (10) **étant caractérisé en ce qu'il** comporte

- une unité de mesure (11) configurée pour mesurer à partir du capteur de tension un signal représentatif d'au moins une portion de période de la tension périodique, l'au moins une portion de période ayant une durée inférieure à la partie de période et étant incluse dans ladite partie de période,
- une unité d'amplification (17) configurée pour amplifier le signal représentatif obtenu par l'unité de mesure par un gain (GA, GB, GC) déterminé en l'absence de défaut électrique du circuit électrique (1) et sur la base d'une tension de référence (Vnom) commune à l'ensemble des phases du circuit électrique (1),
- une unité d'estimation (12) configurée pour estimer une image vectorielle de ladite tension périodique à partir du signal représentatif amplifié (VAc, VBc, VCc) de la tension fournie par l'unité d'amplification (17) après sa vectorisation.

9. Dispositif d'estimation (10) selon la revendication 8, dans lequel l'unité d'amplification comporte un module de filtrage récursif (200) configuré pour appliquer un filtre passe-bas récursif au signal représentatif amplifié (VAc, VBc, VCc).

10. Circuit électrique (1) au moins biphasé comportant pour chacune de ses phases un capteur de tension apte à fournir un signal représentatif (VAr, VBr, VCr) d'au moins une partie de la tension périodique, **caractérisé en ce qu'il** comporte un dispositif d'estimation (10) selon l'une quelconque des revendications 8 et 9.

**Patentansprüche**

1. Verfahren zum Schätzen einer periodischen Spannung, wie etwa einer Eingangsspannung, von einer der Phasen eines zumindest zweiphasigen elektrischen Schaltkreises, der für jede seiner Phasen einen Spannungssensor umfasst, wobei jeder Spannungssensor geeignet ist, ein repräsentatives Signal (VAr, VBr, VCr) für zumindest einen Periodenteil der periodischen Spannung (VA, VB, VC) der Phase bereitzustellen,
wobei das Verfahren **dadurch gekennzeichnet ist, dass** es die folgenden Schritte umfasst:

- Messen des repräsentativen Signals (VAr, VBr, VCr) für zumindest einen Periodenteilabschnitt der periodischen Spannung der Phase ausgehend von dem Spannungssensor, wobei der zumindest eine Periodenteilabschnitt eine geringere Zeitdauer hat als der Periodenteil und in dem Periodenteil enthalten ist,
- Verstärken des repräsentativen Signals (VAr, VBr, VCr) mit einer Verstärkung (GA, GB, GC), die bei Ausbleiben eines elektrischen Fehlers des elektrischen Schaltkreises (1) und auf der Grundlage einer allen Phasen des elektrischen Schaltkreises (1) gemeinsamen Referenzspannung (Vnom) bestimmt wird,
- Vektorisieren des verstärkten repräsentativen Signals (VAc, VBc, VCc) der periodischen Spannung (VA, VB, VC),
- Schätzen ausgehend von dem vektorisierten, verstärkten repräsentativen Signal (VAc, VBc, VCc) der periodischen Spannung (VA, VB, VC), um ein Vektorbild der periodischen Spannung (VA, VB, VC) bereitzustellen, wobei ein Schritt des Bestimmens der Verstärkung (GA, GB, GC) vorgesehen ist, wobei dieser Schritt alle n Iterationen, mit n als positive ganze Zahl größer als 1, die folgenden Unterschritte umfasst:
- Erkennen eines eventuellen elektrischen Fehlers,
- wenn kein elektrischer Fehler erkannt wird, Berechnen der Verstärkung (GA, GB, GC) auf der Grundlage des repräsentativen Signals (VAr, VBr, VCr) und der Referenzspannung (Vnom), wobei eine in einem vorhergehenden Bestimmungsschritt berechnete Verstärkung (GA, GB, GC) beibehalten wird, wenn ein elektrischer Fehler erkannt wird.

2. Schätzverfahren nach Anspruch 1,
wobei der Unterschritt des Erkennens eines eventuellen elektrischen Fehlers die folgenden Operationen umfasst:

- Bestimmen von zumindest einem Wert aus den Werten für die maximale Spannung (VAmax, VBmax, VCmax) und die minimale Spannung (VAmin, VBmin, VCmin) des repräsentativen Signals aus den gemessenen Änderungen des repräsentativen Signals (VAm, VBm, VCm) während einer gegebenen Zeitdauer, wobei derselbe Wert für die andere(n) Phase(n) des elektrischen Schaltkreises bestimmt wird,
- Vergleichen des genannten Wertes mit den für die andere(n) Phase(n) erhaltenen Werten, wobei ein elektrischer Fehler erkannt wird, wenn der für eine der Phasen erhaltene Wert gegenüber dem für die andere(n) Phase(n) des Schaltkreises erhaltenen Wert abweicht.

3. Schätzverfahren nach Anspruch 1 oder 2,
wobei der Unterschritt des Berechnens der Verstärkung (GA, GB, GC), wenn kein elektrischer Fehler erkannt ist, die folgenden Operationen umfasst:

- Bestimmen der gemittelten Amplitude ($\|VAr\|$, $\|VBr\|$, $\|VCr\|$) des repräsentativen Signals (VAr, VBr, VCr) während einer Analysezeitdauer,
- Berechnen der Verstärkung (GA, GB, GC) aus der gemittelten Amplitude ($\|VAr\|$, $\|VBr\|$, $\|VCr\|$) während der Analysezeitdauer und aus der nominalen Referenzspannung (Vnom), wobei dieses Berechnen vorzugsweise

$$GX = \frac{V_{nom}}{\|VXr\|}$$

gemäß der folgenden Gleichung erfolgt: mit GX als Verstärkung, Vnom als Referenzspannung, $\|VXr\|$ als über die Analysezeitdauer gemittelte Amplitude,
wobei die vorherige Verstärkung (GA, GB, GC), die in einem vorherigen Bestimmungsschritt berechnet wurde, beibehalten wird, wenn ein elektrischer Fehler erkannt wird.

4. Verfahren nach einem der Ansprüche 1 bis 3,
wobei der Schätzschritt den folgenden Unterschritt umfasst:

- Anwenden eines Tiefpassfilters, vorzugsweise vom rekursiven Typ, auf das verstärkte repräsentative Signal (VAc, VBc, VCc).

5. Verfahren nach Anspruch 4,
wobei das rekursive Tiefpassfilter die folgenden Operationen umfasst:

- Erkennen einer Veränderung des verstärkten repräsentativen Signals (VAc, VBc, VCc), die größer als ein Aktivierungsschwellenwert (Sa) ist, wobei eine solche Veränderung Signatur eines hochfrequenten Rauschens ist,
- wenn eine Änderung des verstärkten repräsentativen Signals (VAc, VBc, VCc), die größer als der Schwellenwert (Sa) für die Erkennung eines hochfrequenten Rauschens ist, erkannt wird, rekursives Schätzen des verstärkten repräsentativen Signals (VAc, VBc, VCc), um das erkannte hochfrequente Rauschen zu dämpfen.

6. Verfahren nach einem der Ansprüche 1 bis 5,
wobei der Spannungssensor ein Sensor ist, der dazu ausgelegt ist, ein repräsentatives Signal für einen Periodenteil der periodischen Spannung bereitzustellen, und wobei der Schätzschritt den folgenden Unterschritt umfasst:

- Zurücksetzen auf null des geschätzten repräsentativen Signals (VAe, VBe, VCe) außerhalb des Periodenteils, der durch das repräsentative Signal (VAr, VBr, VCr) dargestellt wird.

7. Verfahren nach einem der Ansprüche 1 bis 6,
wobei der Spannungssensor ein Sensor ist, der dazu geeignet ist, ein repräsentatives Signal aus einem ableitenden oder integrierenden Element, wie einer an einer Kapazität (15A, 15B, 15C) des elektrischen Schaltkreises gemessenen Spannung, bereitzustellen, und wobei der Schritt des Schätzens den folgenden Unterschritt umfasst:

- Verschieben der Phase des verstärkten repräsentativen Signals (VAc, VBc, VCc) um 90°.

8. Vorrichtung (10) zum Schätzen einer periodischen Spannung, um eine Spannung einer Phase eines zumindest zweiphasigen elektrischen Schaltkreises (1), wie etwa eine Eingangsspannung des elektrischen Schaltkreises (VA, VB, VC), zu schätzen, wobei der elektrische Schaltkreis (1) für jede seiner Phasen einen Spannungssensor umfasst, der geeignet ist, ein repräsentatives Signal (Var, VBr, VCr) für zumindest einen Teil der periodischen Spannung bereitzustellen,
wobei die Schätzvorrichtung (10) **dadurch gekennzeichnet ist, dass** sie enthält:

- eine Messeinheit (11), die dazu ausgelegt ist, ausgehend von dem Spannungssensor ein repräsentatives Signal für zumindest einen Periodenteilabschnitt der periodischen Spannung zu messen, wobei der zumindest eine Periodenteilabschnitt eine geringere Zeitdauer als der Periodenteil hat und in dem Periodenteil enthalten ist,
- eine Verstärkungseinheit (17), die dazu ausgelegt ist, das von der Messeinheit erhaltene repräsentative Signal mit einer Verstärkung (GA, GB, GC) zu verstärken, die bei Ausbleiben eines elektrischen Fehlers des elektrischen Schaltkreises (1) und auf der Grundlage einer allen Phasen des elektrischen Schaltkreises (1) gemeinsamen Referenzspannung (Vnom) bestimmt wird,
- eine Schätzeinheit (12), die dazu ausgelegt ist, ein Vektorbild der periodischen Spannung aus dem verstärkten repräsentativen Signal (VAc, VBc, VCc) der von der Verstärkungseinheit (17) bereitgestellten Spannung nach dessen Vektorisierung zu schätzen.

**9.** Schätzvorrichtung (10) nach Anspruch 8,
wobei die Verstärkungseinheit ein rekursives Filtermodul (200) umfasst, das dazu ausgelegt ist, ein rekursives Tiefpassfilter auf das verstärkte repräsentative Signal (VAc, VBc, VCc) anzuwenden.

**10.** Elektrischer Schaltkreis (1), der zumindest zweiphasig ist und für jede seiner Phasen einen Spannungssensor umfasst, der geeignet ist, ein repräsentatives Signal (VAr, VBr, VCr) für zumindest einen Teil der periodischen Spannung bereitzustellen,
**dadurch gekennzeichnet, dass** er eine Schätzvorrichtung (10) nach einem der Ansprüche 8 und 9 enthält.

**Claims**

**1.** Method of estimating a periodic voltage, such as an input voltage, of one of the phases of an electrical circuit with at least two phases comprising a voltage sensor for each of its phases, each voltage sensor being capable of outputting a signal (VAr, VBr, VCr) representative of at least a part of period of the periodic voltage (VA, VB, VC) of said phase, the method being **characterised in that** it comprises the following steps:

- measure of the signal (VAr,VBr,VCr) representative of at least a portion of a period of the periodic voltage of the phase starting from the voltage sensor, said at least a portion of a period having a duration less than the part of a period and being included in said part of a period;
- amplification of the representative signal (VAr,VBr,VCr) by a gain (GA, GB, GC) determined in the absence of an electrical fault in the electrical circuit (1) and based on a reference voltage (Vnom) common to all phases in the electrical circuit (1),
- vectorisation of the amplified representative signal (VAc, VBc, VCc) of the periodic voltage (VA, VB, VC);
- estimation from the amplified representative signal (VAc, VBc, VCc) of the vectorised periodic voltage (VA, VB, VC) to output a vector image of said periodic voltage (VA, VB, VC);
in which a gain determination (GA,GB,GC) step is included, said step comprising the following sub-steps once every n iterations, where n is a positive integer greater than 1:
- detection of an electric fault if there is one,
- if no electrical defect is detected, calculation of the gain (GA,GB,GC) based on the representative signal (VAr,VBr,VCr) and the reference voltage (Vnom), a gain (GA,GB,GC) calculated during a previous determination step being kept if an electrical fault is detected.

**2.** Estimating method according to claim 1, in which the sub-step to detect an electrical fault if there is one comprises the following operations:

- determination of at least one value among the values of the maximum voltage (VAmax, VBmax, VCmax) and the minimum voltage (VAmin, VBmin, VCmin) of the representative signal starting from variations in the representative signal (VAm,VBm,VCm) measured during a given period of time, the same value being determined for the other phase(s) of the electrical circuit,
- comparison of said value with values obtained for the other phase(s), an electrical fault being detected if the value obtained for one of the phases is different from the value obtained for the other phase(s) of the circuit.

**3.** Estimating method according to claim 1 or 2, in which the sub-step to calculate the gain (GA, GB, GC) if no electrical fault is detected includes the following operations:

- determination of the averaged amplitude (‖VAr‖, ‖VBr‖, ‖VCr‖) of the representative signal (VAr, VBr, VCr) during an analysis duration,

- calculatation of the gain (GA, GB, GC) from the averaged amplitude ($\|VAr\|$, $\|VBr\|$, $\|VCr\|$) during the analysis duration and the nominal reference voltage (Vnom), this calculation preferably being made using the following equation: $$GX = \frac{Vnom}{\|VXr\|}$$ where GX is the gain, Vnom is the reference voltage, $\|VXr\|$ is the amplitude averaged over the analysis duration

the previous gain (GA, GB, GC) calculated during a previous determination step being kept if an electrical fault is detected.

4. Method according to any one of claims 1 to 3, in which the estimating step includes the following sub-step:

- Application of a low pass filter to the amplified representative signal (VAc, VBc, VCc), preferably of the recursive type.

5. Method according to claim 4, in which the recursive low pass filter comprises the following operations:

- detection of a variation of the amplified representative signal (VAc, VBc, VCc) greater than an activation threshold value (Sa), such a variation being the signature of a high frequency noise,
- if a variation of the amplified representative signal (VAc, VBc, VCc) greater than the threshold detection value (Sa) of a high frequency noise is detected, recursive estimation of the amplified representative signal (VAc, VBc, VCc) so as to attenuate the detected high frequency noise.

6. Method according to any one of claims 1 to 5, in which the voltage sensor is a sensor adapted to output a signal representative of a part of period of the periodic voltage, and in which the estimating step includes the sub-step to:

- set the estimated representative signal (VAe, VBe, VCe) to zero outside the part of period represented by the representative signal (VAr, VBr, VCr).

7. Method according to any one of claims 1 to 6, in which the voltage sensor is a sensor adapted to output a representative signal from a differentiating or integrating element such as a voltage measured on a capacitor (15A, 15B, 15C) in the electrical circuit and the estimating step includes a sub-step to:

- shift the phase of the amplified representative signal (VAc, VBc, VCc) by 90°.

8. Device (10) for estimating a periodic voltage to estimate a voltage in a phase of an electrical circuit (1) with at least two phases, such as an input voltage to the electrical circuit (VA, VB, VC), the electrical circuit (1) comprising a voltage sensor for each of its phases capable of outputting a signal (Var, VBr, VCr) representative of at least a part of the periodic voltage,
the estimating device (10) being **characterised in that** it comprises

- a measurement unit (11) configured to measure a signal representative of at least a portion of period of the periodic voltage, said at least a portion of a period having a duration less than the part of a period and being included in said part of a period;
- an amplification unit (17) configured to amplify the representative signal obtained by the measurement unit by a gain (GA, GB, GC) determined when there is no electrical fault in the electrical circuit (1) and based on a reference voltage (Vnom) common to all phases in the electrical circuit (1),
- an estimating unit (12) configured to estimate a vector image of said periodic voltage from the amplified representative signal (VAc, VBc, VCc) of the voltage output by the amplification unit (17) after its vectorisation

9. Estimating device (10) according to claim 8, in which the amplification unit comprises a recursive filter module (200) configured to apply a recursive low pass filter to the amplified representative signal (VAc, VBc, VCc).

10. Electrical circuit (1) with at least two phases comprising a voltage sensor for each of its phases capable of outputting a signal (VAr, VBr, VCr) representative of at least a part of the periodic voltage, **characterised in that** it comprises an estimating device (10) according to any one of claims 8 and 9.

FIG. 1

EP 3 001 206 B1

FIG. 2

FIG. 3

EP 3 001 206 B1

PAZ=0
Tatt=N/3
$\Delta$V=0
EST=0
Sd=5%Vnom
Sa=35%Vnom
Der(1:5)=0

$E_1$

k=k+1

$E_2$

$E_3$

VXe(k)

FIG. 4

E2

E200

E220

$\alpha X(k)=VXc(k)$
$Tatt=Tatt-1$

E210

Oui — PAZ=0 ? — Non

E230

$Tzero=Tzero-1$

E221

Tatt<0 ? — Non

Non — Tzero<0 ? — Oui — E233

Oui

E222

$d\alpha X=[VXc(k)-VXc(k-2)]/2$

$\alpha X(k)=0$

E232

PAZ=0
$\alpha X(k)=VXc(k)$
$Tatt=N/3$

E233

E223

{dαX<0}&
{|dαX|>10%Sd}
&{VXc(k)<Sd} — Non

E224

Oui

PAZ=1
$\Delta V=0$
$Tzero=N/3$
$Tatt=N/3$

E240

$\alpha X(k)$
<0 ? — Oui

E241

$\alpha X(k)=0$

Non

E250

# FIG. 5

E3

E300

E310 — k>N ?

Non / Oui

E330 — $\delta X(k)=\alpha X(k)-\alpha X(k-1)$

E320 — $\Delta V=1$ ?

E331 — EST=1 ?

E340 — Test=Test-1

Oui / Non

Non

E321 — $\delta X(k)>Sa$ ?

Non / Oui

E322 — EST=1
$\Delta V=1$

E341 — Test<0 ?

Oui / Non

E342 — PAZ=1?

Oui / Non

E323

343 — EST=0
Test=0

E350 — EST=1 ?

Oui / Non

E351 — $VXe(k)=VXe(k-1)+$
$sg_x[\alpha X(k)-\alpha X(k-1)]/8$

E352 — $VXe(k)=\alpha X(k)$

E353 — Der(1:4)=Der(2:5)
Der(5)=sign[$\delta X(k)$]

E354 — $\{VXe(k)<0\}=>VXe(k)=0$
$\{VXe(k)>\alpha X(k)\}=>VXe(k)=\alpha X(k)$

E360

FIG. 6

E323

E3230

p=nb(1,Der)
n=nb(-1,Der)

E3231

Oui ← p>3 ? → Non

E3232

sg=+1
Test=N/9

E3233

sg=-1

E3234

E3235

E3237   Non ← n≥3 ? → Oui

Test=N/9

Test=N/3

E3236

E350

FIG. 7

23

FIG. 8A

FIG. 8B

FIG. 8C

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- EP 2731220 A1
- US 20050207198 A1
- US 20130158909 A1
- DE 102011085516 A1
- US 4811236 A
- US 6246332 B1